(19) Europäisches Patentamt
European Patent Office
Office européen des brevets

(11) **EP 0 581 602 B1**

(12) **EUROPEAN PATENT SPECIFICATION**

(45) Date of publication and mention
of the grant of the patent:
**22.09.1999 Bulletin 1999/38**

(51) Int Cl.⁶: **G06F 11/10**, G11C 5/14, G11C 29/00

(21) Application number: **93306029.5**

(22) Date of filing: **30.07.1993**

(54) **Semiconductor memory device with an error checking and correcting circuit**

Halbleiterspeichergerät mit einer Fehlerprüf- und Korrekturschaltung

Dispositif de memoire à semi-conducteur à circuit de vérification et de détection d'erreur

(84) Designated Contracting States:
**DE FR GB IT NL**

(30) Priority: **30.07.1992 KR 1368592**

(43) Date of publication of application:
**02.02.1994 Bulletin 1994/05**

(73) Proprietor: **SAMSUNG ELECTRONICS CO., LTD.**
**Suwon-City, Kyungki-do (KR)**

(72) Inventors:
• **Cho, Sung-Hee**
**Suwon-city, Kyungki-do (KR)**
• **Lee, Hyong-Gon**
**Kwonsun-gu, Suwon-city, Kyungki-do (KR)**

(74) Representative: **Stanley, David William et al**
**DIBB LUPTON**
**BROOMHEAD**
**117 The Headrow, Leeds LS1 5JX (GB)**

(56) References cited:
**EP-A- 0 439 141**          **EP-A- 0 442 301**
**JP-A- 4 332 995**

## Description

The present invention relates to semiconductor memory devices employing an error checking and correcting (ECC) circuit.

As the packing density of semiconductor memory devices increases, bit failures or syndrome bits due to defects in manufacturing steps or electrical stress surges into a memory chip become a factor which significantly affects the yield and reliability of the semiconductor memory devices. In memory devices, e.g. electrically erasable and programmable read only memory (EEPROM) or mask ROM devices, which are non-volatile memories requiring high reliability, the adoption of an ECC circuit is a general tendency. Although the adoption of an ECC circuit can create problems such as increase of chip size owing to added parity cells and speed delay due to the correction circuit, the increased range of the reliability and yield is enough to compensate for the problems. In particular, it is difficult to apply redundancy in a highly integrated ROM device, so that an ECC circuit should be essentially adopted in this device for enhancing the yield and reliability thereof.

The concept of the ECC is as follows. During an input operation, parity is generated by means of input data, and then both the input data and parity bits are stored. During an output operation, the stored data and the parity generated by the input data are compared with each other, thereby detecting and correcting an error. That is, the parity is information developed by means of the input data. For reference, the number of the parity bits required according to the number of data bits is determined in accordance with a Hamming code, which is attained by:

$$2^k \geq m+k+1$$

where "m" denotes the number of data bits and "k" denotes the number of parity bits. Therefore, according to the above inequality, when the number of data bits is eight, the number of parity bits is four. Similarly, when the number of data bits is sixteen, the number of parity bits is five.

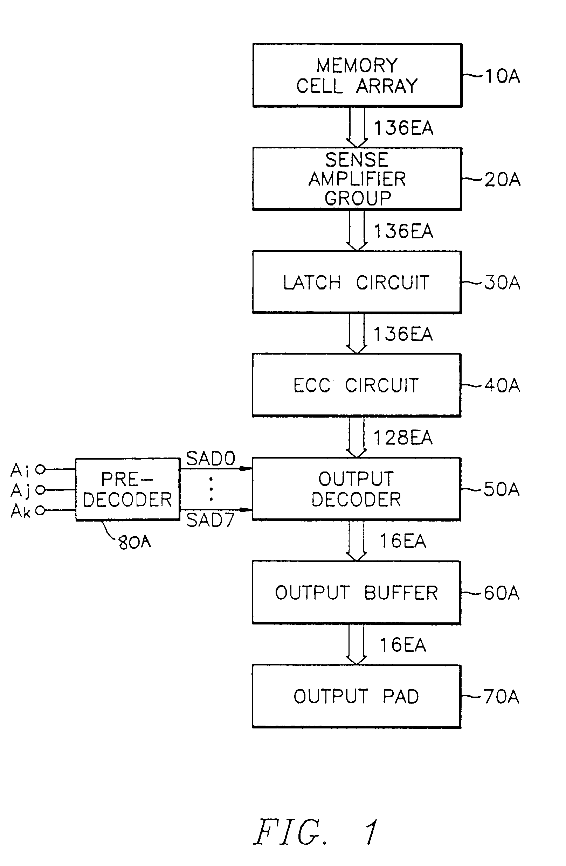

In connection with this, a block diagram of a conventional semiconductor memory device having an ECC circuit for 128 bits is shown in Figure 1 of the accompanying diagrammatic drawings, wherein the number of parity bits is eight. The semiconductor memory device shown in Figure 1 has a memory cell array 10A, a sense amplifier group 20A for sensing data of the memory cell array 10A, a latch circuit 30A for latching the output of the sense amplifier group 20A, an ECC circuit 40A for repairing a syndrome bit, an output decoder 50A for sequentially accessing the 128 bits by 16 bits by means of pre-decoding signals SAD0-SAD7 generated from a pre-decoder 80A, and a data output buffer 60A for providing 16-bit output data to an output pad 70A. In a data access operation of the semiconductor memory device shown in Figure 1, the data of 128 bits is sequentially output by 16 bits after passing the sense amplifier group 20A, the latch circuit 30A and the ECC circuit 40A, so that the data access can be performed at high speed. Such a high-speed data access operation is called "page mode" wherein a data unit consists of 16 bits. However, in a normal mode data access operation, since the sense amplifier group 20A, the latch circuit 30A and ECC circuit 40A are simultaneously activated, power dissipation is the same as that of the page mode. Accordingly, it is necessary to distinguish between the page mode and normal mode for the purpose of an efficient power consumption in the semiconductor memory device. However, distinction between the page mode and normal mode is impossible in the conventional architecture as shown in Figure 1.

Preferred embodiments of the present invention, as set forth in the independent claim, aim to provide an ECC-embedded semiconductor memory device reducing power dissipation during a normal mode data access operation.

It is another aim to provide an ECC-embedded semiconductor memory device capable of an alternative distinction between a normal mode and a page mode in a simple manner.

According to one aspect of the present invention, there is provided a semiconductor memory device comprising:

a memory cell array partitioned into a plurality of sub cell arrays, each of said sub cell arrays having both normal memory cells and parity cells;

a plurality of sense amplifier groups each being connected to one of said sub cell arrays, for performing sensing operation of cell data from said sub cell arrays;

a plurality of error checking and correcting circuits each being connected to one of said sense amplifier groups for repairing syndrome bits within said cell data; and

output decoders each being connected to an output of one of said error checking and correcting circuits;

wherein when said semiconductor memory device is to be operated in a normal mode, one of said sub cell arrays is selected, and when said semiconductor memory device is to be operated in a page mode, all of said sub cell arrays are selected.

A semiconductor memory device as described above may further comprise a block selecting circuit for generating block selecting signals for selecting sub cell arrays, wherein when said semiconductor memory device is to be operated in said normal mode said block selecting circuit receives a plurality of address signals and when said semiconductor memory device is to be operated in said page mode said blocking circuit receives a power supply voltage.

Preferably, when said semiconductor memory device is to be operated in said normal mode one of said sense amplifier group and one of said error checking and correcting circuit which are connected to one sub cell array selected by one of said block selection signals are activated, and when said semiconductor memory device is to be operated in said page mode said plurality of sense amplifier groups and said plurality of error checking and correcting circuits are all activated.

Preferably, a plurality of latch circuits for latching output signals from said sense amplifier groups are provided between said sense amplifier groups and said error checking and correcting circuits.

A semiconductor memory device as above may further comprise a pre-decoder for controlling data access operation of said output decoders.

Preferably, a semiconductor memory device of the invention has a metal layer on an upper portion thereof, and further comprises: a plurality of latch circuits for latching output signals from said sense amplifier groups; and an output buffer for receiving output signals from said output decoder; wherein said semiconductor memory device is put into a specific data access operation mode by means of a change of connection with said metal layer, said change of connection being provided to block selecting means in said semiconductor device.

Preferably, said page mode is selected by providing connection between said metal layer and all inputs of said block selecting means.

It is an advantage of preferred embodiments of the present invention that in a semiconductor memory device having an ECC function, power dissipation is reduced during a normal mode data access operation of the semiconductor memory device.

It is a further advantage of preferred embodiments of the present invention that conversion between a normal mode data access operation and a page mode data access operation can be effected by means of a change of metal layer which is formed on an upper portion of the respective semiconductor memory device.

For a better understanding of the invention, and to show how the same may be carried into effect, reference will now be made, by way of example, to Figures 2 to 4 of the accompanying diagrammatic drawings, in which:

Figure 2 is a functional block diagram of one example of a semiconductor memory device employing a multi-ECC circuit, according to the present invention, when put into a normal mode data access operation;

Figure 3A is a circuit diagram of a first decoder shown in Figure 2;

Figure 3B is a circuit diagram of an address transition detector shown in Figure 2;

Figure 3C is a circuit diagram of a second decoder shown in Figure 2; and

Figure 4 is a functional block diagram of a semiconductor memory device similar to that of Figure 2, when put into a page mode data access operation.

In the figures, like reference numerals denote like or corresponding parts.

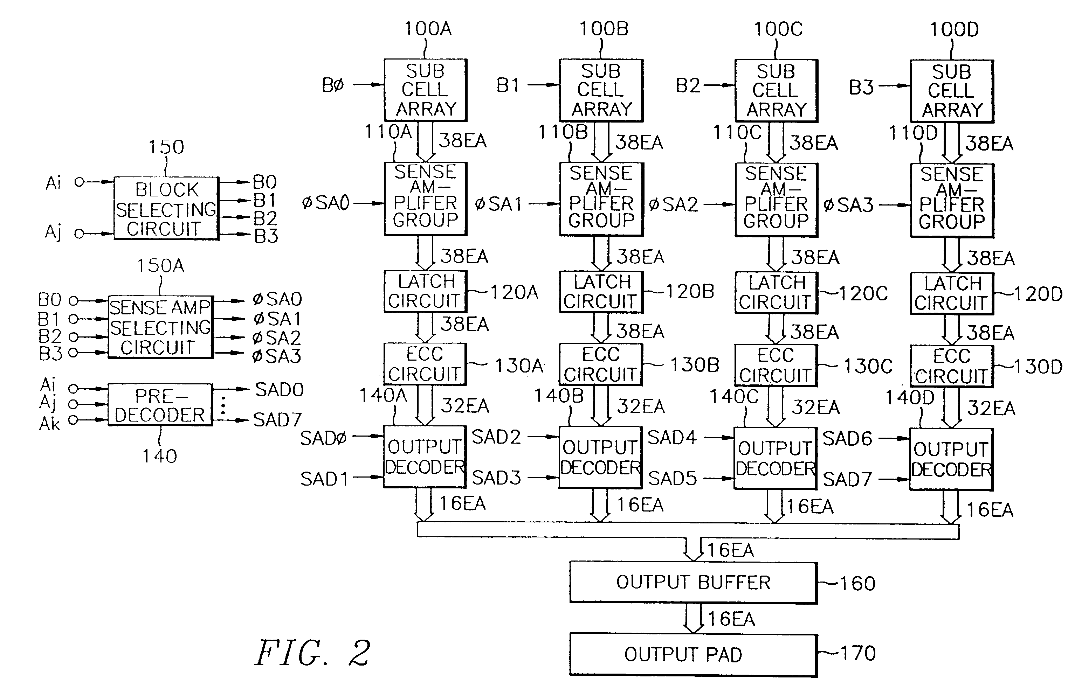

Figure 2 shows one example of the architecture of a semiconductor memory device including a multi-ECC circuit according to the present invention, when the semiconductor memory device is being operated in a normal mode data access operation (hereinafter briefly referred to as "normal mode"). A memory cell array is divided into four sub cell arrays 100A, 100B, 100C and 100D, each of which has normal cells and parity cells. The peripheral circuitry corresponding to the sub cell arrays divided into four sections is formed of four sense amplifier groups 110A, 110B, 110C and 110D, each sense amplifier group having normal sense amplifiers and parity sense amplifiers, being connected to the sub cell arrays 100A, 100B, 100C and 100D, respectively; four latch circuits 120A, 120B, 120C and 120D for latching output signals supplied from the sense amplifier groups 110A, 110B, 110C and 110D, respectively; four ECC circuits 130A, 130B, 130C and 130D (this plural architecture can be called "multi-ECC circuit") connected respectively to the latch circuits 120A, 120B, 120C and 120D for repairing syndrome bits; output decoders 140A, 140B, 140C and 140D respectively connected to the ECC circuits 130A, 130B, 130C and 130D; an output buffer 160 for receiving output signals of the output decoders 140A, 140B, 140C and 140D; and an output pad 170. In addition, there is provided a block selecting circuit 150 receiving address signals Ai and Aj in a normal mode (in a page mode the input of the block selecting circuit 150 is connected to a power supply voltage Vcc), and thereby generating block selecting signals B0-B3 to select the sub cell arrays 100A, 100B, 100C or 100D; a sense amplifier selecting circuit 150A receiving the block selecting signals B0-B3 from the block selecting circuit 150 and thereby generating sense amplifier selecting signals ΦSA0-ΦSA3 to select the sense amplifier groups 110A, 110B, 110C and 110D; and a pre-decoder 140 receiving address signals Ai, Aj and Ak and thereby generating pre-decoding signals SAD0-SAD7 which are applied to output decoders 140A-140D so as to let each of the output decoders divide output signals of 32 bits from each of the ECC circuits 130A-130D by 16 bits, each 16-bit data being transferred to the output buffer 160 in turn.

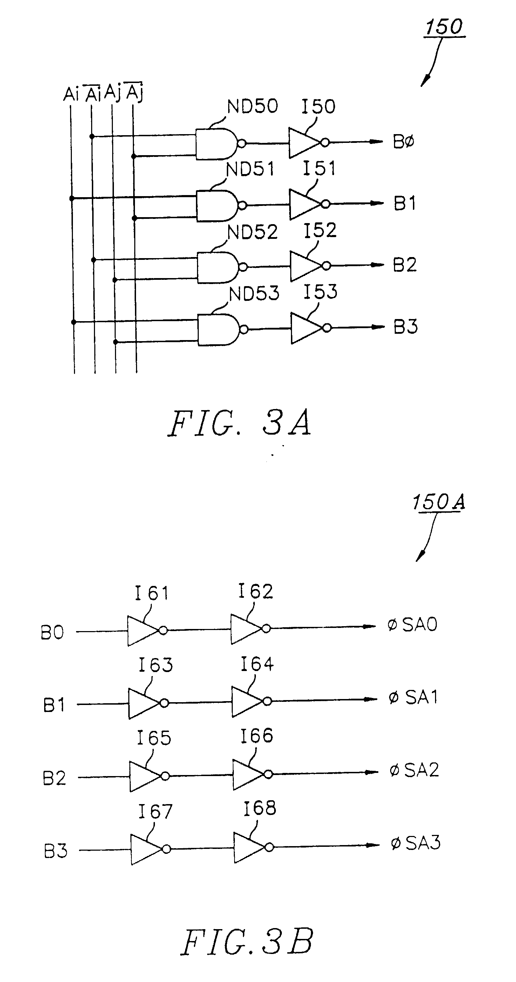

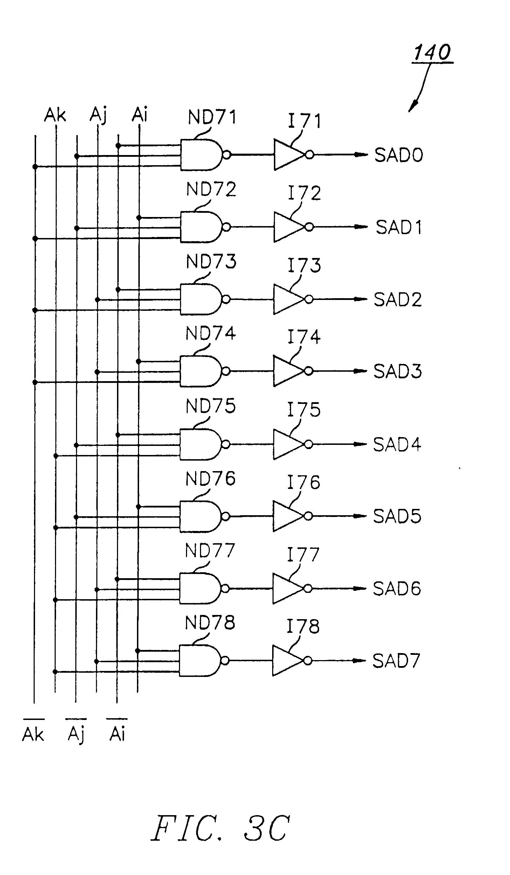

The block selecting circuit 150, as shown in Figure 3A, consists of NAND gates ND50-ND53 receiving address signals Ai and Aj in the normal mode, and inverters 150-153 receiving output signals generated from the NAND gates ND50-ND53. It is noted that, especially in a page mode, the four input lines of address signals Ai and Aj are commonly connected to a power supply voltage Vcc by means of a metal layer interconnection.

The sense amplifier selecting circuit 150A has four identical circuits as shown in Figure 3B corresponding to the four block selecting signals B0-B3, each consisting of two inverters. Inverters I61, I63, I65 and I67 receive the block selecting signals B0 to B3, and inverters I62, I64, I66 and I68 generate sense amplifier selecting signals ΦSA0-ΦSA3 from the output signals of the inverters I61, I63, I65 and I67.

The pre-decoder 140, as shown in Figure 3C, consists of NAND gates ND71 to ND78 which receive address signals Ai, Aj and Ak, and inverters I71 to I78 which generate pre-decoding signals SAD0 to SAD7 to control the quantity of data passed through the output decoders 140A, 140B, 140C and 140C in Figure 2.

Since the sub cell arrays are divided into four sections, the sense amplifier groups, latch circuits, ECC circuits and output decoders are respectively divided into four sections to correspond to the divided number of the sub cell arrays. In Figure 2, the reason for requiring 38 sense amplifiers in all for each block in the sense amplifier groups is that 32 sense amplifiers are required for sensing normal data, and six parity data sense amplifiers are need for repairing single syndrome bits in 32 data bits.

The constitutional characteristics of the architecture shown in Figure 2 reside in that the memory cell array is divided into four sub cell arrays for decreasing power dissipation and accelerating speed. At the same time, it has a multi-ECC circuit, wherein an ECC circuit is provided in each sub cell array so as to repair the syndrome bits. Since the four sub cell arrays 100A, 100B, 100C and 100D are operated independently to each other, each of the ECC circuits 130A, 130B, 130C and 130D is separately provided for a respective one of the sub cell arrays 100A, 100B, 100C and 100D. That is, a specific ECC circuit belonging to a certain sub cell array can be free from operational interference with an adjacent sense amplifier group belong to another sub cell array. Therefore, instead of the ECC circuit operated by means of a combination of the output signals from 128 sense amplifiers in the conventional circuit shown in Figure 1, the illustrated embodiment of the present invention is formed of 32-bit ECC circuits operated by means of the combination of the output signals from 32 sense amplifiers per each sub cell array.

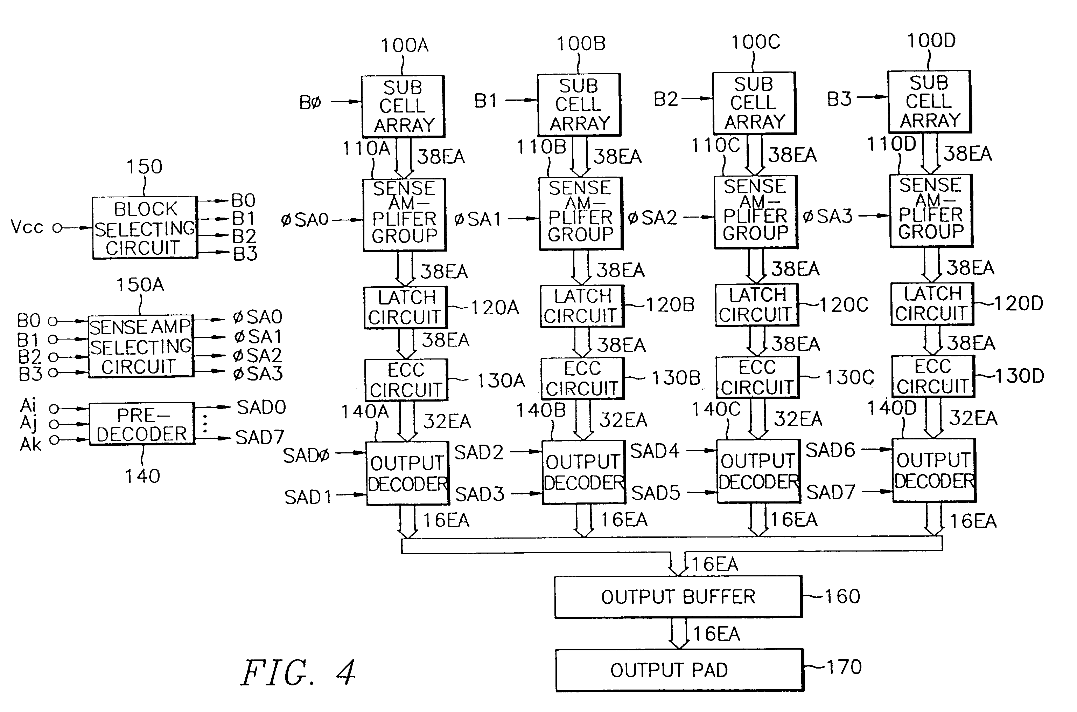

Referring to Figure 4, there is shown the architecture of a semiconductor memory device put into a page mode data access operation (hereinafter briefly referred to as "page mode"), wherein its architecture is the same as that of Figure 2 except that the linking of an input terminal of the block selecting circuit 150 is converted to input power supply voltage Vcc instead of the address signals Ai and Aj. This conversion of linking with the input terminal of the block selecting circuit 150 can be achieved by means of changing (from the address signals Ai and Aj to the power supply voltage Vcc) an interconnection pattern of a metal layer which is provided to define to where the input terminal of the block selecting circuit 150 is coupled, being effected during a metal layer forming step of a manufacturing process for the semiconductor memory device.

Operations in a normal mode and page mode according to the constructions shown in Figure 2 and Figure 4 will be described below.

In the normal mode, the input of the block selecting circuit 150 becomes address signals Ai and Aj to alternatively select one of the sub cell arrays. Assuming that the sub cell array 100A is selected by the block selecting signal B0 which is activated, data read from the sub cell array 100A are sensed and amplified in the sense amplifier group 110A, wherein normal data are sensed by the normal sense amplifiers and parity data are sensed by the parity sense amplifiers in the sense amplifier group 110A. The data are then latched in the latch circuit 120A, and passed through the ECC circuit 130A. At this time, if a syndrome bit exists, it is repaired in the ECC circuit 130A. Thereafter, the data are decoded in the output decoder 140A and applied to the output buffer 160. Here, the non-selected sub cell arrays 100B, 100C and 100D, sense amplifier groups 110B, 110C and 110D, latch circuits 120B, 120C and 120D, and output decoders 140B, 140C and 140D are in a disabled state, while the sub cell array 100A is selected which makes the sense amplifier group 110A, latch circuit 120A, ECC circuit 130A and the output decoder 140A activated. Thus, power dissipation is obviously decreased relative to that of a conventional circuit during the normal mode data access operation.

In the meantime, the semiconductor memory device in the page mode (wherein one page equals eight words) can be easily utilized only by changing a metal layer constituting an upper portion of the chip wherein the input terminal of the block selecting circuit 150 is connected to a power supply voltage Vcc instead of linking with the address signals Ai and Aj. Referring to Figure 4, 38-bit data consisting of 32-bit normal data and 6-bit parity data are respectively read from each of the sub cell arrays 100A to 100D, because the block selecting signals B0 to B3 are all activated due to the power supply voltage input of the logic high level. Referring to Figure 3A, since in the page mode all of the input terminals of the NAND gates ND50 to ND53 are coupled to the power supply voltage Vcc which is at a CMOS logic high level, the block selecting signals B0 to B3 as output signals of the inverters I50 to I53 become logic high levels which are activated states to select all the sub cell arrays 100A to 100D. The block selecting signals B0 to B3 activated as high logic levels, referring to Figure 3B, cause all the sense amplifier selecting signals ΦSA0 to ΦSA3 to be activated to select all the sense amplifier groups 110A to 110D. After parallel data access operation from the sub cell arrays 100A through 100D to the latch circuits 120A through 120D, 38-bit data consisting of 32-bit normal data and 6-bit parity data are applied to each of the ECC circuits 130A through 130D so that any syndrome bit within the 32-bit normal data is detected and repaired by the 6-bit parity data in each of the ECC circuits. Then 32-bit normal data repaired in each of the ECC circuits 130A to 130D are applied to each of the output decoders 140A to 140D. Each of the output decoders applies 16-bit data to the output buffer 160, which is controlled by the pre-decoding signals SAD0 to SAD7 generated from the pre-decoder 140 shown in Figure 3C. Such data access operation through the output decoders 140A to 140D is the same as that of the output decoder 50A in Figure 1.

The architectures shown in Figures 2 and 4 are preferred embodiments of the present invention, but it should be understood by those skilled in the art that various changes in form and details of the elements may be effected in the block architecture.

The above-described embodiment of the present invention realizes a multi-ECC circuit, wherein the plurality of ECC circuits correspond to a plurality of sub cell arrays. Furthermore, the architecture of the semiconductor memory device makes the conversion between the normal mode and page modes possible by the change of a metal layer connection relating to block selecting portions. As a result, the illustrated embodiment of the present invention is advantageous for reducing power dissipation in a semiconductor memory device having an ECC function.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1.    A semiconductor memory device comprising:

a memory cell array partitioned into a plurality of sub cell arrays (100A-D), each of said sub cell arrays (100A-D) having both normal memory cells and parity cells;

a plurality of sense amplifier groups (110A-D) each being connected to one of said sub cell arrays (100A-D), for performing sensing operation of cell data from said sub cell arrays (100A-D);

a plurality of error checking and correcting circuits (130A-D) each being connected to one of said sense amplifier groups (110A-D) for repairing syndrome bits within said cell data; and

output decoders (140A-D) each being connected to an output of one of said error checking and correcting circuits (130A-D);

wherein when said semiconductor memory device is to be operated in a normal mode, one of said sub cell arrays (100A-D) is selected, and when said semiconductor memory device is to be operated in a page mode, all of said sub cell arrays (100A-D) are selected.

2.    A semiconductor memory device as claimed in claim 1, further comprising a block selecting circuit (150) for generating block selecting signals (B0-B3) for selecting sub cell arrays (100A-D), wherein when said semiconductor memory device is to be operated in said normal mode said block selecting circuit (150) receives a plurality of address signals (Ai, Aj) and when said semiconductor memory device is to be operated in said page mode said blocking circuit (150) receives a power supply voltage (Vcc).

3.    A semiconductor memory device as claimed in claim 1 or 2, wherein when said semiconductor memory device is to be operated in said normal mode one said sense amplifier group (110A-D) and one said error checking and correcting circuit (130A-D) which are connected to one sub cell array (100A-D) selected by one of said block selection signals (B0-B3) are activated, and when said semiconductor memory device is to be operated in said page mode said plurality of sense amplifier groups (110A-D) and said plurality of error checking and correcting circuits (130A-D) are all activated.

4.    A semiconductor memory device as claimed in claim 1, 2 or 3, wherein a plurality of latch circuits (120A-D) for latching output signals from said sense amplifier groups (110A-D) are provided between said sense amplifier groups (110A-D) and said error checking and correcting circuits (130A-D).

**5.** A semiconductor memory device as claimed in any of the preceding claims, further comprising a pre-decoder (140) for controlling data access operation of said output decoders (140A-D).

**6.** A semiconductor memory device according to claim 1 having a metal layer on an upper portion thereof, further comprising:

a plurality of latch circuits (120A-D) for latching output signals from said sense amplifier groups (110A-D); and
an output buffer (160) for receiving output signals from said output decoder (140A-D);

wherein said semiconductor memory device is put into a specific data access operation mode by means of a change of connection with said metal layer, said change of connection being provided to block selecting means (150) in said semiconductor device.

**7.** A semiconductor device according to claim 6 wherein said page mode is selected by providing connection between said metal layer and all inputs (Ai, /Ai, Aj, /Aj) of said block selecting means (150).

**Patentansprüche**

**1.** Eine Halbleiterspeichereinrichtung, die umfaßt:

ein Speicherzellenfeld, das in eine Mehrzahl Unterzellenfelder (100A-D) unterteilt ist, wobei jedes der genannten Unterzellenfelder (100A-D) normale Speicherzellen und auch Paritätszellen aufweist;

eine Mehrzahl Leseverstärkergruppen (110A-D), von denen jede mit einem der genannten Unterzellenfelder (100A-D) verbunden ist, um eine Leseoperation von Zellendaten von den genannten Unterzellenfeldern (100A-D) auszuführen;

eine Mehrzahl Fehlerprüf- und -Korrekturschaltungen (130A-D), von denen jede mit einer der genannten Leseverstärkergruppen (110A-D) verbunden ist, um Syndrombits innerhalb der genannten Zellendaten zu reparieren; und

Ausgangsdecodierer (140A-D), von denen jeder mit einem Ausgang einer der genannten Fehlerprüf- und -Korrekturschaltungen (130-D) verbunden ist;

wobei, wenn die genannte Halbleiterspeichereinrichtung in einem normalen Modus betrieben werden soll, eines der genannten Unterzellenfelder (100A-D) ausgewählt wird, und wenn die genannte Halbleiterspeichereinrichtung in einem Seitenmodus betrieben werden soll, alle der genannten Unterzellenfelder (100A-D) ausgewählt werden.

**2.** Eine Halbleiterspeichereinrichtung, wie in Anspruch 1 beansprucht, die ferner eine Blockauswählschaltung (150) zur Erzeugung von Blockauswählsignalen (B0-B3) umfaßt, um Unterzellenfelder (100A-D) auszuwählen, wobei, wenn die genannte Halbleiterspeichereinrichtung in dem genannten normalen Modus betrieben wird, die genannte Blockauswählschaltung (150) eine Mehrzahl Adressensignale (Ai, Aj) erhält, und wenn die ge-nannte Halbleiterspeichereinrichtung in dem ge-nannten Seitenmodus betrieben wird, die genannte Blockschaltung (150) eine Versorgungsspannung (Vcc) erhält.

**3.** Eine Halbleiterspeichereinrichtung, wie in Anspruch 1 oder 2 beansprucht, wobei, wenn die ge-nannte Halbleiterspeichereinrichtung in dem ge-nannten normalen Modus betrieben werden soll, eine genannte Leseverstärkergruppe (110A-D) und eine genannte Fehlerprüf- und -Korrekturschaltung (130A-D), die mit einem Unterzellenfeld (100A-D) verbunden sind, das durch eines der genannten Blockauswählsignale (B0-B3) ausgewählt worden ist, aktiviert werden, und wenn die genannte Halb-leiterspeichereinrichtung in dem genannten Seiten-modus betrieben werden soll, die genannte Mehrzahl Leseempfängergruppen (110A-D) und die ge-nannte Mehrzahl Fehlerprüf-und-Korrekturschal-tungen (130A-D) alle aktiviert werden.

**4.** Eine Halbleiterspeichereinrichtung, wie in Anspruch 1, 2 oder 3 beansprucht, wobei eine Mehrzahl Zwischenspeicherschaltungen (120A-D) zum Zwischenspeichern von Ausgangssignalen von den genannten Leseverstärkergruppen (110A-D) zwischen den genannten Leseverstärkergruppen (110A-D) und den genannten Fehlerprüf-und-Korrekturschaltungen (130A-D) vorgesehen sind.

**5.** Eine Halbleiterspeichereinrichtung, wie in irgendeinem der vorhergehenden Ansprüche beansprucht, die des weiteren einen Vordecodierer (140) umfaßt, um eine Datenzugriffsoperation der genannten Ausgangsdecodierer (10A-D) zu steuern.

**6.** Eine Halbleiterspeichereinrichtung gemäß Anspruch 1, die eine Metallschicht auf einem oberen Abschnitt von sich aufweist, die des weiteren umfaßt:

eine Mehrzahl Zwischenspeicherschaltungen (120A-D), um Ausgangssignale von den genannten Leseverstärkergruppen (110A-D) zwischenzuspeichern;

einen Ausgangspuffer (160), um Ausgangssignale von dem genannten Ausgangskodierer (140A-D) zu erhalten;

wobei die Halbleiterspeichereinrichtung in einen spezifischen Datenzugriffs-Operationsmodus mittels einer Verbindungsänderung mit der genannten Metallschicht gebracht wird, wobei die genannte Verbindungsänderung bei der Blockauswähleinrichtung (150) in der genannten Halbleitereinrichtung vorgesehen wird.

7. Eine Halbleiterspeichereinrichtung gemäß Anspruch 6, wobei der Seitenmodus ausgewählt wird, indem eine Verbindung zwischen der genannten Metallschicht und allen Eingängen (Ai, /Ai, Aj, /Aj) der genannten Blockauswähleinrichtung (150) vorgesehen wird.

**Revendications**

1. Dispositif de mémoire à semiconducteurs comprenant :

un groupement de cellules de mémoire séparé en une pluralité de sous-groupements de cellules (100A à D) , chacun desdits sous-groupements de cellules (100A à D) comportant tout à la fois des cellules de mémoire normales et des cellules de parité ;
une pluralité de groupes d'amplificateurs de détection (110A à D), connecté chacun à l'un desdits sous-groupements de cellules (100A à D) pour effectuer une opération de détection de données de cellule venant desdits sous-groupements de cellules (100A à D) ;
une pluralité de circuits de vérification et de correction d'erreur (130A à D) connecté chacun à l'un desdits groupes d'amplificateurs de détection (110A à D) pour réparer des bits de syndrome à l'intérieur desdites données de cellule ; et
des décodeurs de sortie (140A à D) connecté chacun à une sortie de l'un desdits circuits de vérification et de correction d'erreur (130A à D) ;

dans lequel, lorsque ledit dispositif de mémoire à semiconducteurs doit fonctionner dans un mode normal, l'un desdits sous-groupements de cellules (100A à D) est sélectionné, et, lorsque ledit dispositif de mémoire à semiconducteurs doit fonctionner dans un mode page, tous lesdits sous-groupements de cellules (100A à D) sont sélectionnés.

2. Dispositif de mémoire à semiconducteurs selon la revendication 1, comprenant de plus un circuit de sélection de bloc (150) pour générer des signaux de sélection de bloc (B0 à B3) pour sélectionner des sous-groupements de cellules (100A à D), dans lequel, lorsque ledit dispositif de mémoire à semiconducteurs doit fonctionner dans ledit mode normal, ledit circuit de sélection de bloc (150) reçoit une pluralité de signaux d'adresse (Ai, Aj), et, lorsque ledit dispositif de mémoire à semiconducteurs doit fonctionner dans ledit mode page, ledit circuit de blocage (150) reçoit une tension d'alimentation (Vcc).

3. Dispositif de mémoire à semiconducteurs selon la revendication 1 ou 2, dans lequel, lorsque ledit dispositif de mémoire à semiconducteurs doit fonctionner dans ledit mode normal, l'un desdits groupes d'amplificateurs de détection (110A à D) et l'un desdits circuits de vérification et de correction d'erreur (130A à D) qui sont connectés à un sous-groupement de cellules (100A à D) sélectionné par l'un desdits signaux de sélection de bloc (B0 à B3) sont activés, et, lorsque ledit dispositif de mémoire à semiconducteurs doit fonctionner dans ledit mode page, ladite pluralité de groupes d'amplificateurs de détection (110A à D) et ladite pluralité de circuits de vérification et de correction d'erreur (130A à D) sont tous activés.

4. Dispositif de mémoire à semiconducteurs selon la revendication 1, 2 ou 3, dans lequel une pluralité de circuits de verrouillage (120A à D) pour verrouiller des signaux de sortie venant desdits groupes d'amplificateurs de détection (110A à D) sont disposés entre lesdits groupes d'amplificateurs de détection (110A à D) et lesdits circuits de vérification et de correction d'erreur (130A à D).

5. Dispositif de mémoire à semiconducteurs selon l'une quelconque des revendications précédentes, comportant de plus un pré-décodeur (140) pour commander l'opération d'accès aux données desdits décodeurs de sortie (140A à D).

6. Dispositif de mémoire à semiconducteurs selon la revendication 1, comportant une couche métallique sur une partie supérieure de celui-ci, comprenant de plus :

une pluralité de circuits de verrouillage (120A à D) pour verrouiller les signaux de sortie venant desdits groupes d'amplificateurs de détection (110A à D) ; et
un tampon de sortie (160) pour recevoir des signaux de sortie dudit décodeur de sortie (140A à D) ;
dans lequel ledit dispositif de mémoire à semiconducteurs est mis dans un mode d'opération d'accès aux données spécifique au moyen d'un changement de connexion avec ladite couche métallique, ledit changement de connexion étant établi pour les moyens de sélection de bloc (150) dans ledit dispositif à semiconducteurs.

7. Dispositif de mémoire à semiconducteurs selon la revendication 6, dans lequel ledit mode de page est sélectionné en établissant une connexion entre ladite couche métallique et toutes les entrées (Ai, /Ai, Aj, /Aj) desdits moyens de sélection de bloc (150).

FIG. 1

EP 0 581 602 B1

FIG. 2

*FIG. 3A*

*FIG. 3B*

*FIG. 3C*

FIG. 4